# EUROPEAN PATENT APPLICATION

(11) **EP 4 831 670 A1**
(43) Date of publication of application: **28.10.2026**
(21) Application number: 25172401.9
(22) Date of filing: 24.04.2025
(51) Int. Cl.: G01R 33/3815, G01R 33/421

(54) **Z-SHIELD IN OUTER VACUUM CONTAINER OF AN MRI MAGNET**

(71) Applicant: Koninklijke Philips N.V., 5656 AE Eindhoven (NL)
(72) Inventor: FORTHMANN, Peter, Eindhoven (NL); LIPS, Oliver, Eindhoven (NL); VERNICKEL, Peter, 5656AG Eindhoven (NL); AMTHOR, Thomas Erik, Eindhoven (NL)
(74) Representative: Philips Intellectual Property & Standards

(57) **Abstract**

An MRI magnet includes a vacuum container having an inner cylindrical vacuum container wall defining a bore passing through the vacuum container, an outer vacuum container wall encircling the inner cylindrical vacuum container wall, and annular sidewalls connecting between the outer vacuum container wall and the inner cylindrical vacuum container wall. Superconducting magnet windings are disposed in the vacuum container, encircling the bore. A Z-gradient main coil is disposed in the bore, and a Z-gradient shield coil is disposed on or in the inner cylindrical vacuum container wall.

## Description

### FIELD OF THE INVENTION

The following relates generally to the magnetic resonance (MR) imaging arts, MR magnet arts, MR gradient coil arts, and related arts.

### BACKGROUND OF THE INVENTION

Magnetic resonance imaging (MRI) systems typically include, among other components, gradient coils. The gradient coils can have shield components used to reduce a stray magnetic field that could heat up inside of a cryostat of the MRI system by induction, and to decouple a z-gradient from magnet coils of a magnet of the MRI system. In some examples, such gradient coils can include both main coils and shield coils.

In MRI systems with low-temperature superconducting magnets, actively shielded gradient coils are used because low-temperature superconducting magnets cannot handle heat generated by a stray-field generated eddy currents of an unshielded gradient coil. A high-temperature superconducting magnet is more robust to handle these eddy currents, because high-temperature superconducting magnets have a higher temperature margin, making unshielded gradient coils more feasible.

Z-gradient coils are gradient coils used to create or regulate a gradient magnetic field along a z-axis, that is, along the axial direction of the bore of the MRI system. With an unshielded Z-gradient coil, there is a problem of inductive coupling with the magnet coils. This coupling leads to the induction of high voltages in the magnet coils. One solution is to apply active shielding to the Z-gradient coil. However, active shielding reduces the efficiency of the Z-gradient coil.

The following discloses certain improvements to overcome these problems and others.

### SUMMARY OF THE INVENTION

In some embodiments disclosed herein, a magnetic resonance imaging (MRI) device includes a vacuum container having an inner cylindrical vacuum container wall defining a bore passing through the vacuum container. A superconducting magnet comprising a plurality of superconducting coils is disposed inside the vacuum container and encircles the inner cylindrical vacuum container wall. A Z-gradient main coil is disposed in the bore. A Z-gradient shield coil is disposed on or in the inner cylindrical vacuum container wall of the vacuum container.

In some embodiments disclosed herein, a cryostat for an MRI magnet includes a vacuum container having an inner cylindrical vacuum container wall defining a bore passing through the vacuum container, an outer vacuum container wall encircling the inner cylindrical vacuum container wall, and annular sidewalls connecting between the outer vacuum container wall and the inner cylindrical vacuum container wall. A Z-gradient shield coil is disposed on or in the inner cylindrical vacuum container wall.

One advantage resides in providing an MRI system with a Z-gradient shield coil disposed on an inner cylindrical vacuum container wall of the vacuum container of the MRI system (i.e., on or in the cylindrical vacuum container wall defining the bore of the MRI system).

Another advantage resides in providing an MRI system with a Z-gradient shield coil disposed within the inner cylindrical vacuum container wall of the vacuum container of the MRI system.

Another advantage resides in providing an MRI system with X- and Y-gradient coils disposed between the main and shield Z-gradient coils.

Another advantage resides in providing an arrangement of the Z-gradient shield coil as described above, in combination with an inner vacuum container wall of a vacuum container being made of a non-metallic material.

A given embodiment may provide none, one, two, more, or all of the foregoing advantages, and/or may provide other advantages as will become apparent to one of ordinary skill in the art upon reading and understanding the present disclosure.

### BRIEF DESCRIPTION OF THE DRAWINGS

The disclosure may take form in various components and arrangements of components, and in various steps and arrangements of steps. The drawings are only for purposes of illustrating the preferred embodiments and are not to be construed as limiting the disclosure.
Fig. 1 diagrammatically illustrates perspective and axial section views of a magnetic resonance (MR) imaging device including a vacuum container in accordance with the present disclosure.
Fig. 2 diagrammatically illustrates an axial section view of a first embodiment in which a Z-gradient shield coil is disposed on an outer surface of the inner cylindrical vacuum container wall of the vacuum container of Fig. 1.
Fig. 3 diagrammatically illustrates an enlarged sectional view of a portion of the inner cylindrical vacuum container wall of the vacuum container in accordance with the first embodiment of Fig. 2.
Fig. 4 diagrammatically illustrates a perspective view of the first embodiment of Figs. 2 and 3 including the inner cylindrical vacuum container wall and sidewalls of the vacuum container, the magnet windings, and the Z-gradient coil, but with the outer vacuum container wall omitted.
Fig. 5 diagrammatically illustrates a perspective view of the first embodiment of Figs. 2-4 including the inner cylindrical vacuum container wall of the vacuum container and the Z-gradient coil, but with the magnet windings and the sidewalls and outer vacuum container wall omitted.
Fig. 6 diagrammatically illustrates an axial section view of a second embodiment in which a Z-gradient shield coil is disposed on an inner surface of the inner cylindrical vacuum container wall of the vacuum container of Fig. 1.
Fig. 7 diagrammatically illustrates an enlarged sectional view of a portion of the inner cylindrical vacuum container wall of the vacuum container in accordance with the second embodiment of Fig. 6.
Fig. 8 diagrammatically illustrates an axial section view of a third embodiment in which a Z-gradient shield coil is embedded in the inner cylindrical vacuum container wall of the vacuum container of Fig. 1.

### DETAILED DESCRIPTION OF EMBODIEMENTS

Traditionally, main and shield layers of a gradient coil are potted together into one body and are disposed in the bore of the magnet (and hence outside of the vacuum chamber). As disclosed herein, the Z-gradient main coil and the Z-gradient shield coil are separate parts. The Z-gradient main coil resides inside the magnet bore, while the Z-gradient shield coil turns are embedded in the inner cylindrical vacuum container wall (also referred to herein as the inner rollup) of the outer vacuum container (OVC) (also referred to herein as the vacuum container). In some embodiments, the Z-gradient shield coil is disposed at the outer diameter of the inner cylindrical vacuum container wall in order to maximize the radial distance to the main turns - in such embodiments, electrical feedthroughs into the vacuum container enable the Z-gradient shield coil turns to be connected electrically.

The MRI magnet can be a high temperature superconducting magnet. Since the MRI magnet should be able to cope with unshielded gradients as far as thermal effects are concerned due to eddy currents, the Z-gradient shield coils only have to reduce the voltage coupling of the generated Z-gradient magnetic fields with the magnet coils to an acceptable level. This means that the Z-gradient shield coil can have a reduced current density compared with a traditional shield, which aims at complete stray field elimination.

To facilitate electromagnetic performance of the Z-gradient shield coil disposed on or in the inner cylindrical vacuum container wall, a composite cryostat may be employed (or, in a variant embodiment, only the inner cylindrical vacuum container wall may be composite). The Z-gradient shield coil can, in some embodiments, be advantageously disposed on the outer diameter (OD) of the inner cylindrical vacuum container wall, which maximizes the distance between the Z-gradient main and shield coils. from an origin on which a Z-gradient shield coil can be. By contrast, with a metal cryostat (or a metal inner cylindrical vacuum container wall), the metallic wall close to the Z-gradient shield coil can pose problems regarding eddy currents. Also, a composite inner cylindrical vacuum container wall facilitates embodiments in which the Z-gradient shield coil is embedded in the inner cylindrical vacuum container wall.

Heat generation by the Z-gradient shield coil is an important consideration when it is disposed on or in the inner cylindrical vacuum container wall. The vacuum container is at room temperature, so some heating is tolerable, but temperatures should not rise too far above room temperature. Optionally, water cooling may be provided for the Z-gradient shield coil disposed on or in the inner cylindrical vacuum container wall. If the Z-gradient shield coil windings are embedded in the inner cylindrical vacuum container wall, or is disposed on its inner diameter (ID, i.e., outside the vacuum) then heating by the Z-gradient shield coil may be less pronounced.

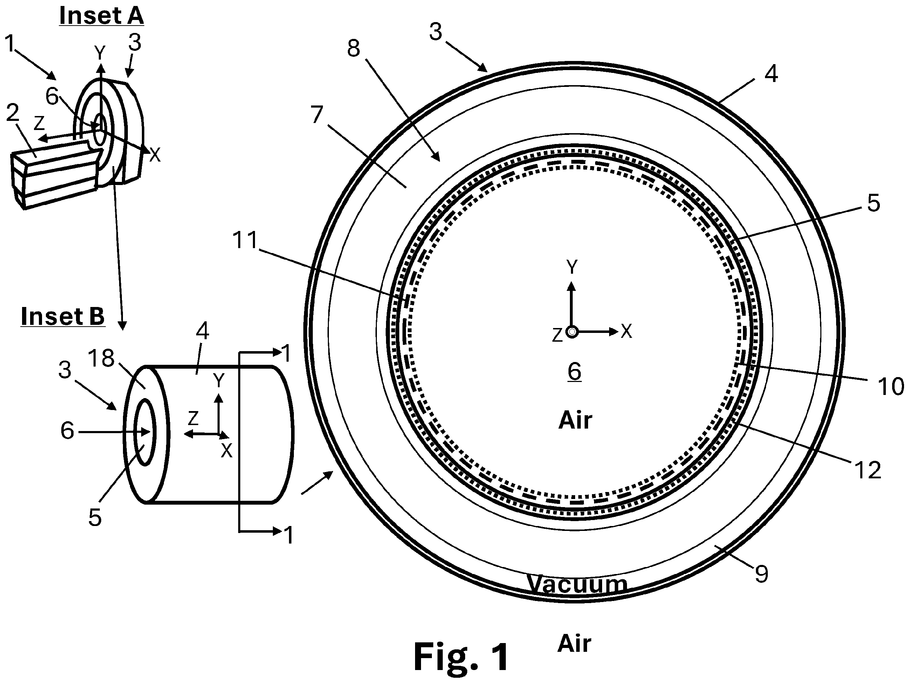

With reference to Fig. 1, an illustrative perspective view of a magnetic resonance (MR) imaging system or device **1** (shown in INSET A of Fig. 1) for imaging a subject (not shown - e.g., a human subject such as a medical patient, or a veterinary subject, or an archaeological mummy, et cetera) comprises a magnetic resonance (MR) imaging scanner (also referred to herein as an MRI scanner), which in the illustrative example includes a patient support **2** and a vacuum vessel or container **3** (also referred to herein as a cryostat **3).** As shown in INSET B of Fig. 1, the vacuum container **3** includes an inner cylindrical vacuum container wall **5** defining a bore **6** passing through the vacuum container **3,** an outer vacuum container wall **4** encircling the inner cylindrical vacuum container wall **5,** and annular sidewalls **18** (one of which is visible in Inset B) connecting between the outer vacuum container wall **4** and the inner cylindrical vacuum container wall **5.** The outer and inner cylindrical vacuum container walls **4** and **5** and sidewalls **18** define an annular vacuum volume disposed between the outer and inner cylindrical vacuum container walls **4** and **5.** In use, a patient or other imaging subject (not shown) is loaded onto the patient support **2,** which is typically motorized to enable the patient to be moved into the bore 6 which also serves or defines (at least in part) the imaging region in which MRI images are acquired. It should be noted that the outer and inner cylindrical vacuum container walls **4** and **5** are generally cylindrical, but may deviate from mathematically precise cylindrical geometries.

In some embodiments, the inner cylindrical vacuum container wall **5** can be made from a nonmetallic material, such as glass fiber or a plastic material. In some embodiments, the entire vacuum container 3 may be made of a nonmetallic material, such as glass fiber or a plastic material. The main drawing of Fig. 1 shows a cross sectional view of the vacuum container **3** taken along Section 1-1 indicated in INSET B, with the sectional view also diagrammatically showing contents of the vacuum container 3 and gradient coils secured thereto. Fig. 1 also shows an X-Y-Z Cartesian coordinate system used herein to refer to directions. In the illustrative coordinates, the Z-direction is the axial direction and coincides with the central axis of the bore **6** (which is also the central axis of the inner cylindrical vacuum container wall **5** defining the bore **6).** The X- and Y-directions are mutually orthogonal and are also orthogonal to the axial or Z-direction. Hence, a plane parallel with the X-Y plane is transverse to the axial or Z-direction, and may be referred to herein as an axial plane. In particular, the Section 1-1 forming the main drawing of Fig. 1 is an axial plane oriented perpendicular to the axial or Z-direction.

As best shown in Fig. 1, the inner cylindrical vacuum container wall **5** defines a bore **6** passing through the vacuum container **3.** During imaging, the subject is positioned on the subject support **2** and moved within the bore **6** for MRI imaging. The vacuum container **3** contains a superconducting or resistive magnet **7** generating a static (*B*₀) magnetic field (e.g., higher than 3 Tesla (T)). The magnet **7** comprises a plurality of superconducting coils **8** configured to generate the static (*B*₀) magnetic field, which may in some nonlimiting examples be in a range of about 1.5 Tesla to 7 Tesla, although a B₀ field outside this range is also contemplated. The superconducting coils **8** are annular and surround the inner cylindrical vacuum container wall **5** and the bore **6,** and are disposed in the annular volume defined between the outer and inner cylindrical vacuum container walls **4** and **5.** During use, the vacuum container **3** is evacuated so that the superconducting coils **8** are in vacuum. The cryostat **3** is configured (e.g., by a cryogenic refrigerator and suitable thermal straps or couplings and/or the like) to cool and maintain the superconducting coils **8** at a temperature below the critical temperature (T_{c}) for superconductivity, so as to maintain the superconducting coils **8** in their superconducting state to ensure that the superconducting coils **8** generate the magnetic fields necessary for imaging. As shown in Fig. 1, the superconducting coils **8** are disposed inside the vacuum container **3** and encircle the inner cylindrical vacuum container wall **5,** and encircle the bore **6.** For example, the superconducting coils **8** are spaced from an inner surface of the outer vacuum container wall surface **4** via a vacuum **9.** In some embodiments, the superconducting magnet **7** is a low helium volume (LHV) magnet with a small volume (e.g., tens of liters or less) of liquid helium in a sealed volume within the vacuum **9.** In other embodiments, the superconducting magnet **7** does not include any helium. The sealed volume containing the helium of the LHV magnet substantially prevents helium boiloff. Not shown in Fig. 1 are refrigeration components for cooling the helium of the LHV magnet, such as a cryogenic cold head driven by a helium compressor.

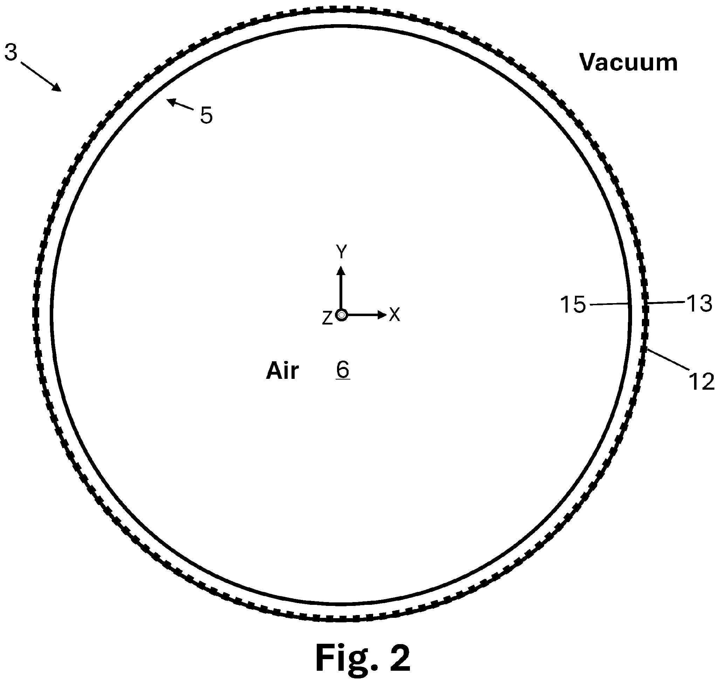

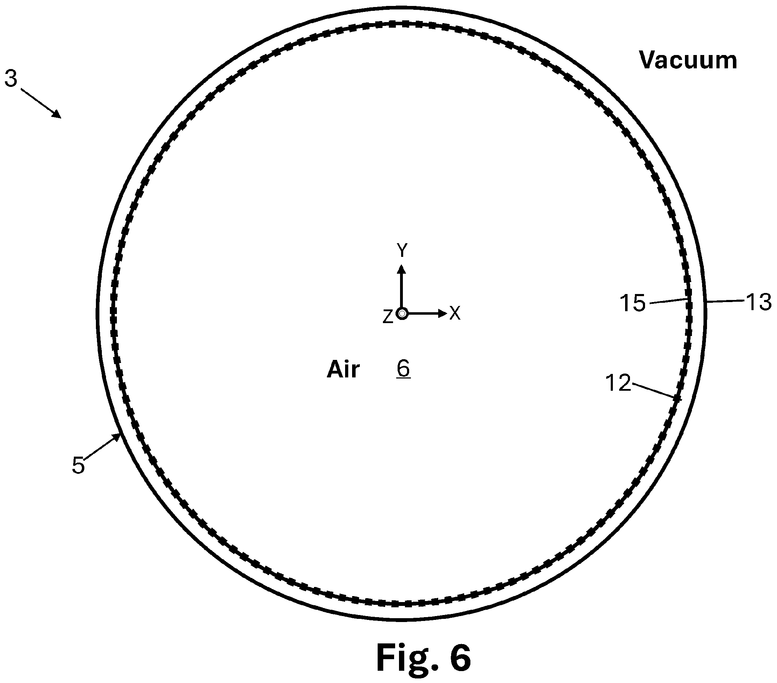

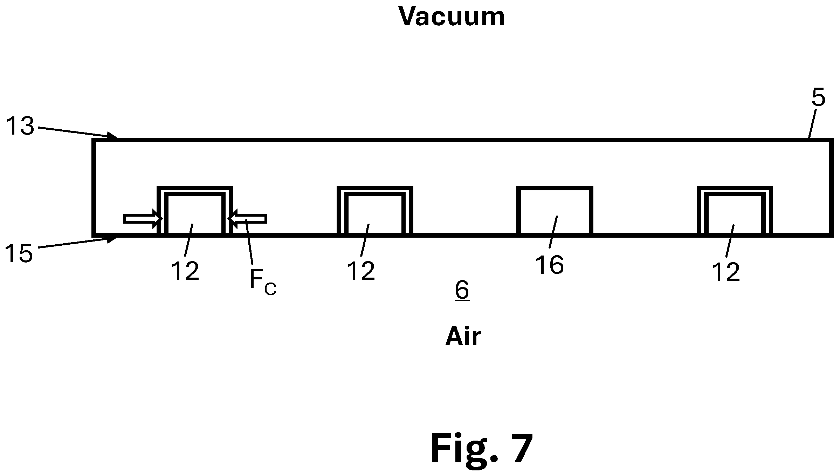

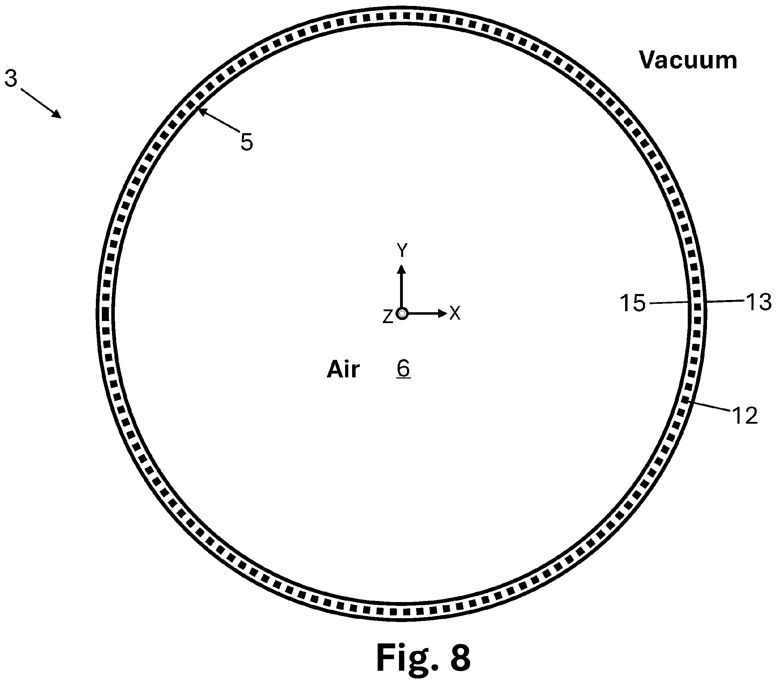

The MRI device **1** also includes multiple gradient coils for superimposing magnetic field gradients on the B₀ magnetic field. The magnetic field gradients can serve various purposes, such as spatially limiting magnetic resonance excitation to a particular region (e.g., an axial plane or thin slab), spatially encoding magnetic resonance (e.g., to implement phase-encoding and/or readout encoding, spiral encoding, or so forth), spoiling magnetic resonance, and/or so forth. The magnet **7** and the gradient coils are arranged concentrically about the bore 6. The magnet **7** is spaced from the inner cylindrical vacuum container wall **5** via a gap (not labeled in Fig. 1). As shown in Fig. **1** (starting from the "center" of the bore **6),** a Z-gradient main coil **10** is disposed in the bore **6.** The gradient coils can also include one or more X-gradient coils and one or more Y-gradient coils (collectively labeled with reference character **11)** disposed in the bore **6,** and encircling the Z-gradient main coil **10.** The inner cylindrical vacuum container wall **5** encircles the Z-gradient main coil **10** and the X- and Y-gradient coils **11** (which can include both main coils and shield coils, which are not shown). A Z-gradient shield coil **12** is disposed at a larger diameter, on or in the inner cylindrical vacuum container wall **5** of the vacuum container **3.** Hence, the Z-gradient coil has a Z-gradient main coil **10** and a Z-gradient shield coil **12** which are separated from each other. As shown in Fig. 1, the superconducting coils **8** of the magnet **7,** the Z-gradient main coil **10,** the X- and Y-gradient coils **11,** and the Z-gradient shield coil **12** are also concentric about the bore **6,** with the superconducting coils **8** of the magnet **7** being concentric about the bore **6** at a larger diameter than any of the gradient coils **10, 11, 12.** Each of these coils can be wound with multiple turns. In the example shown in Fig. 1, the Z-gradient shield coil **12** is disposed within the inner cylindrical vacuum container wall **5** (see also Fig. 8). However, the Z-gradient shield coil **12** can alternatively be positioned inside the vacuum container **3** on the outer diameter of the inner cylindrical vacuum container wall **5** (see Figs. 2-5), or can be positioned inside the bore 6 on the inner diameter of the inner cylindrical vacuum container wall **5** (see Figs. 6 and 7), as further described below.

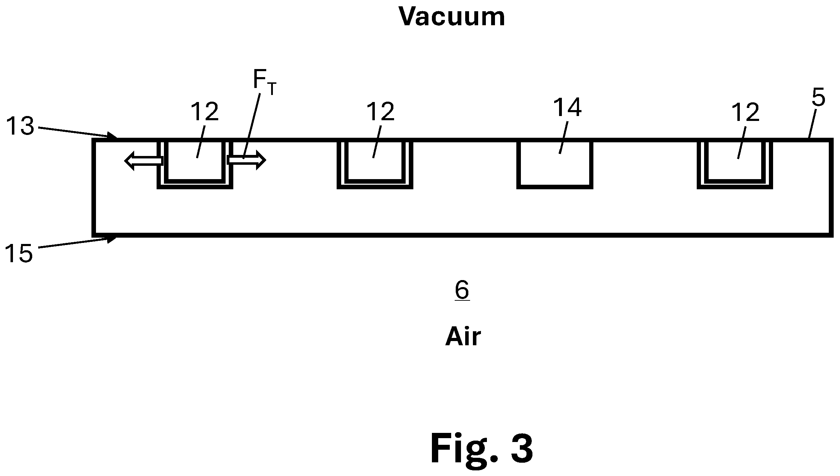

With continuing reference to Fig. 1, Figs. 2 and 3 show a first embodiment, in which the Z-gradient shield coil **12** is disposed inside the vacuum container **3** and on an outer surface **13** of the inner cylindrical vacuum container wall **5** of the vacuum container **3.** As further labeled in Fig. 2, the inner cylindrical vacuum container wall **5** also has an inner surface **15.** The outer surface **13** of the inner cylindrical vacuum container wall **5** is exposed to the vacuum contained in the vacuum container **3;** while the inner surface **15** of the inner cylindrical vacuum container wall **5** faces the bore **6** and is exposed to atmosphere (i.e., air). In some embodiments, as shown in Fig. 3, the Z-gradient shield coil **12** is disposed on the outer surface **13** of the inner cylindrical vacuum container wall **5** by being embedded in the outer surface **13** of the inner cylindrical vacuum container wall **5.** Fig. 3 shows that the Z-gradient shield coil **12** is disposed in grooves **14** spaced along the outer surface **13** of the inner cylindrical vacuum container wall **5** of the vacuum container **3.** To illustrate the grooves **14,** one turn of the Z-gradient shield coil **12** is omitted from the second-from-the-right groove **14.** The turns of Z-gradient shield coil **12** are disposed in the grooves **14** to save space, which means that the thickness of the inner cylindrical vacuum container wall **5** of the vacuum container **3** is reduced at the position of the turns.

Fig. 3 also diagrammatically indicates tensile force **F_{T}** that is experienced by the windings of the Z-gradient shield coil **12** disposed on the outer diameter surface **13** of the inner cylindrical vacuum container wall **5** during MRI operation due to the pressure difference between the vacuum inside the vacuum container **3** and the air in the bore **6.** To accommodate this tensile force, the turns of the Z-gradient shield coil **12** are tightly fit into the grooves **14,** and/or can be glued in the grooves **14** using epoxy or the like. As shown in Figs. 2 and 3, the Z-gradient shield coil **12** is wound about the outer surface **13** with multiple turns to fit within the spaced-apart grooves **14.** In some embodiments, a water cooling jacket or tubing (not shown) is arranged relative to the inner cylindrical vacuum container wall **5** of the vacuum container **3** to cool the Z-gradient shield coil **12.**

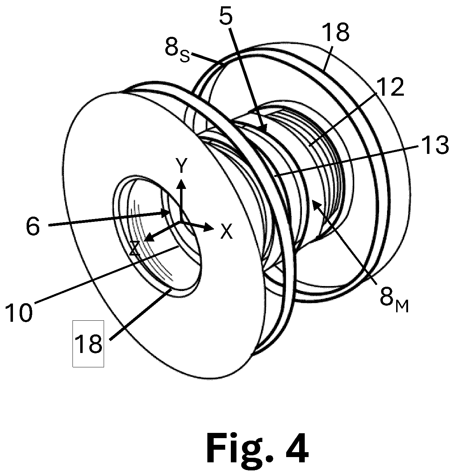

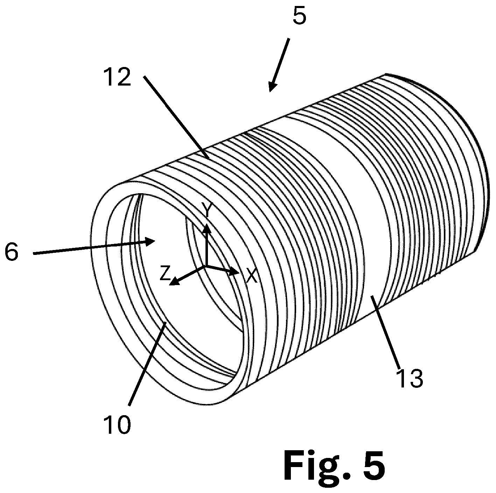

Figs. 4 and 5 show perspective views of the example embodiment of Figs. 2 and 3. Fig. 4 shows a perspective view of the inner cylindrical vacuum container wall **5** and the sidewalls **18** of the vacuum container **3,** but omits the outer vacuum container wall **4** to reveal the interior of the vacuum container **3.** The magnet windings as shown in Fig. 4 include main magnet windings **8_{M}** and shield magnet windings **8s,** with the main magnet windings **8_{M}** disposed at a smaller diameter around the Z-axis than the shield magnet windings **8_{S}.** Fig. 5 shows a similar perspective view as Fig. 4, but further omits the sidewalls **18** and the magnet windings **8_{M}** and **8_{S}.** As seen in both Figs. 4 and 5, the Z-gradient shield coil **12** in the embodiment of Figs. 2-5 is disposed on the outer diameter surface **13** of the inner vacuum container wall **5,** and hence is inside the vacuum of the vacuum container.

With continuing reference to Fig. 1, Figs. 6 and 7 show a second embodiment, in which the Z-gradient shield coil **12** is disposed outside of the vacuum container **3** and on the inner surface **15** of the inner cylindrical vacuum container wall **5.** Hence, in this second embodiment, the Z-gradient shield coil **12** is exposed to air in the bore **6.** In some embodiments, the Z-gradient shield coil **12** is disposed on the inner surface **15** of the inner cylindrical vacuum container wall **5** by being embedded in the inner surface **15.** This is best shown in Fig. **7****,** which shows that the Z-gradient shield coil **12** is disposed in grooves **16** spaced along the inner surface **15** of the inner cylindrical vacuum container wall **5** of the vacuum container **3.** To illustrate the grooves **16,** one turn of the Z-gradient shield coil **12** is omitted from the second-from-the-right groove **16.** The turns of Z-gradient shield coil **12** are embedded in the grooves **16** to save space, which means that the thickness of the vacuum container **3** is reduced at the position of the turns. Fig. 7 also diagrammatically indicates compressive force **F_{C}** that is experienced by the windings of the Z-gradient shield coil **12** disposed on the inner diameter surface **15** of the inner cylindrical vacuum container wall **5** during MRI operation due to the pressure difference between the vacuum inside the vacuum container **3** and the air in the bore **6.** This compressive force **F_{C}** advantageously helps retain the windings of the Z-gradient shield coil **12** in their respective grooves **16.** The turns may also be tightly fit into the grooves **16,** and/or can be glued in the grooves **16** by epoxy or the like, to further assist in retention. As shown in Figs. 6 and 7, the Z-gradient shield coil **12** is disposed on the inner surface **15** with multiple turns to fit within the spaced-apart grooves **16.** In some embodiments, a water cooling jacket or tubing (not shown) is arranged relative to the inner cylindrical vacuum container wall 5 of the vacuum container **3** to cool the Z-gradient shield coil **12.**

With continuing reference to Fig. 1, Fig. 8 shows a third embodiment, in which the Z-gradient shield coil **12** is embedded inside the inner cylindrical vacuum container wall **5.** As shown in Fig. 8, the Z-gradient shield coil **12** is disposed between the outer surface **13** and the inner surface **15** of the inner cylindrical vacuum container wall **5** of the vacuum container **3.** The Z-gradient shield coil **12** fills a portion or all of the space between the outer surface **13** and the inner surface **15.**

In the foregoing embodiments, at least the inner cylindrical vacuum container wall **5** of the vacuum container **3** can be advantageously non-metallic and not electrically conductive, in order that the Z-gradient shield coil **12** not induce eddy currents in the inner cylindrical vacuum container wall **5.** For example, the inner cylindrical vacuum container wall **5** may be made of a composite or plastic material, such as glass fiber epoxy. In some embodiments, it is contemplated for the entire vacuum container **3** to be made of a composite or plastic material.

With reference back to Fig. 1, in some embodiments, the X- and Y-gradient coils **11** are disposed between the Z-gradient main coil **10** and the Z-gradient shield coil **12,** where the latter is disposed on (or embedded in) the inner cylindrical vacuum container wall **5** of the vacuum container **3.** Put another way, the X- and Y-gradient coils **11** are disposed in the bore **6** encircling the Z-gradient main coil **10,** and the inner cylindrical vacuum container wall **5** (on or in which the Z-gradient shield coil **12** resides) encircles the X- and Y-gradient coils **11.** This advantageously maximizes the separation between the Z-gradient main coil **10** and the Z-gradient shield coil **12.**

The disclosure has been described with reference to the preferred embodiments. Modifications and alterations may occur to others upon reading and understanding the preceding detailed description. It is intended that the exemplary embodiment be construed as including all such modifications and alterations insofar as they come within the scope of the appended claims or the equivalents thereof.

## Claims

1. A magnetic resonance imaging (MRI) device **(1),** comprising:
a vacuum container **(3)** having an inner cylindrical vacuum container wall **(5)** defining a bore (6) passing through the vacuum container;
a superconducting magnet **(7)** comprising a plurality of superconducting coils **(8)** disposed inside the vacuum container and encircling the inner cylindrical vacuum container wall;
a Z-gradient main coil **(10)** disposed in the bore; and
a Z-gradient shield coil **(12)** disposed on or in the inner cylindrical vacuum container wall of the vacuum container.

2. The MRI device **(1)** of claim 1, wherein the Z-gradient shield coil **(12)** is disposed inside the vacuum container **(3)** and on, or embedded in, an outer surface **(13)** of the inner cylindrical vacuum container wall **(15).**

3. The MRI device **(1)** of claim 2, wherein the Z-gradient shield coil **(12)** is disposed in grooves **(14)** formed in the outer surface **(13)** of the inner cylindrical vacuum container wall **(5).**

4. The MRI device **(1)** of claim 2, further comprising:
a water cooling jacket or tubing arranged to cool the Z-gradient shield coil **(12).**

5. The MRI device **(1)** of claim 1, wherein the Z-gradient shield coil **(12)** is disposed outside the vacuum container **(3)** and on, or embedded in, an inner surface **(15)** of the inner cylindrical vacuum container wall **(5).**

6. The MRI device **(1)** of claim 5, wherein the Z-gradient shield coil **(12)** is disposed in grooves (16) formed in the inner surface **(15)** of the inner cylindrical vacuum container wall **(5).**

7. The MRI device **(1)** of claim 1, wherein the Z-gradient shield coil **(12)** is embedded inside the inner cylindrical vacuum container wall **(5).**

8. The MRI device **(1)** of any one of claims 1-7, further comprising:
X- and Y-gradient coils **(11)** disposed in the bore **(6)** encircling the Z-gradient main coil **(10),** wherein the inner cylindrical vacuum container wall **(5)** encircles the X- and Y-gradient coils.

9. The MRI device **(1)** of any one of claims 1-8, wherein at least the inner cylindrical vacuum container wall **(5)** of the vacuum container **(3)** comprises a nonmetallic material.

10. The MRI device **(1)** of any one of claims 1-8, wherein at least the inner cylindrical vacuum container wall **(5)** of the vacuum container **(3)** comprises a glass fiber or plastic material.

11. A cryostat **(2)** for a magnetic resonance imaging (MRI) magnet **(7),** the cryostat comprising:
a vacuum container **(3)** having an inner cylindrical vacuum container wall **(5)** defining a bore **(6)** passing through the vacuum container, an outer vacuum container wall **(4)** encircling the inner cylindrical vacuum container wall, and annular sidewalls **(18)** connecting between the outer vacuum container wall and the inner cylindrical vacuum container wall; and
a Z-gradient shield coil **(12)** disposed on or in the inner cylindrical vacuum container wall.

12. The cryostat **(2)** of claim 11, wherein the Z-gradient shield coil **(12)** is disposed: inside the vacuum container **(3)** and on, or embedded in, an outer surface **(13)** of the inner cylindrical vacuum container wall; or in grooves (14) formed in the outer surface (13) of the inner cylindrical vacuum container wall (5).

13. The cryostat **(2)** of claim 12, further comprising:
a water cooling jacket or tubing arranged to cool the Z-gradient shield coil **(12).**

14. The cryostat **(2)** of claim 11, wherein the Z-gradient shield coil **(12)** is disposed: outside the vacuum container **(3)** and on, or embedded in, an inner surface **(15)** of the inner cylindrical vacuum container wall **(5);** or in grooves **(16)** formed in the inner surface **(15)** of the inner cylindrical vacuum container wall **(5).**

15. The cryostat **(2)** of any one of claims 11-14, further comprising:
a Z-gradient main coil **(10)** disposed inside the bore **(6);**
X- and Y-gradient coils **(11)** disposed in the bore **(6)** encircling the Z-gradient main coil **(10),** wherein the inner cylindrical vacuum container wall **(5)** encircles the X- and Y-gradient coils.
